# EUROPEAN PATENT SPECIFICATION

(11) **EP 1 467 216 B1**
(45) Date of publication and mention of the grant of the patent: **13.06.2007**
(21) Application number: 04251015.6
(22) Date of filing: 24.02.2004
(51) Int. Cl.: G01R 33/028, H01L 43/00, G01R 33/02, G01R 33/04

(54) **Method for manufacturing magnetic field detecting element**
Verfahren zur Herstellung eines Magnetfelddetektors
Procédé de fabrication d'un dispositif de détection de champs magnétiques

(30) Priority: 25.02.2003 KR 2003011807; 28.05.2003 KR 2003034191
(43) Date of publication of application: 13.10.2004
(60) Divisional application: 05076754.0
(73) Proprietor: SAMSUNG ELECTRONICS CO., LTD., Suwon-city, Gyeonggi-do (KR)
(72) Inventor: Shim, Dong-sik, Paldal-gu, Suwon-si, Gyeonggi-do (KR); Choi, Sang-on, Yeongtong-gu, Suwon-si, Gyeonggi-do (KR); Na, Kyung-won, Songpa-gu, Seoul (KR); Park, Hae-seok, Guro-gu Seoul (KR); Hwang, Jun-sik, Yongin-si, Gyeonggi-do (KR)
(74) Representative: Ertl, Nicholas Justin

(56) References cited:
- EP-A- 1 345 038
- EP-A- 1 441 234
- EP-A- 1 447 674
- DE-A- 4 220 186
- US-B1- 6 411 086
- US-B1- 6 414 564
- US-B1- 6 429 651

## Description

### BACKGROUND

The present invention relates to a method for manufacturing a magnetic field detecting device by forming a soft magnetic core and a coil in a thin film type on a semiconductor substrate using a semiconductor process.

A magnetic sensor using a soft magnetic material and a coil has been used as a magnetic sensor of high sensitivity for a long time. Such magnetic sensor is usually manufactured by a coil wound on a soft magnetic core, and requires an electronic circuit for obtaining magnetic field proportional to measured magnetic field. Recently, a method for realizing such magnetic filed detecting element of the magnetic sensor in form of the soft magnetic thin film core and a plane thin film coil on the semiconductor substrate using the semiconductor process, has been suggested.

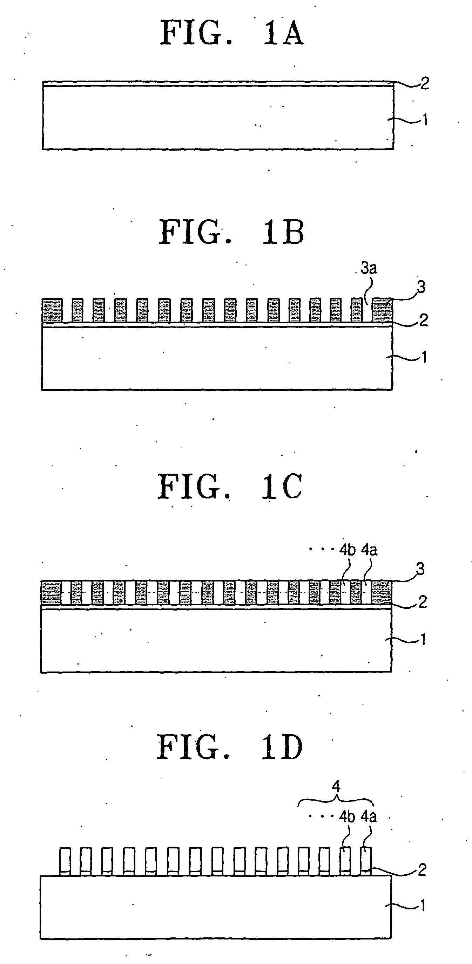

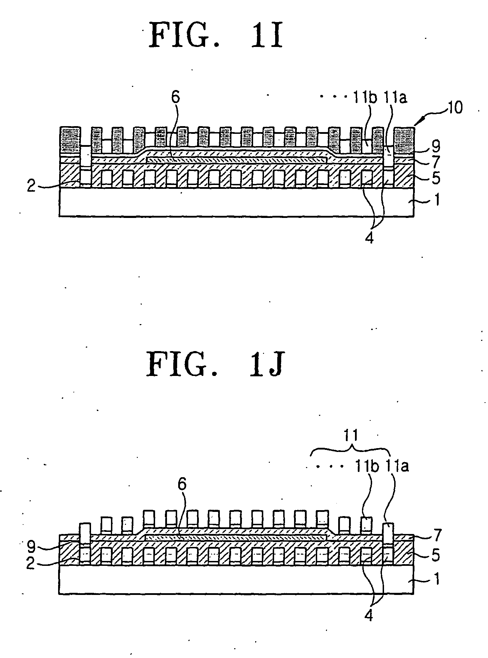

A general method for manufacturing a magnetic field detecting element using the semiconductor process will be briefly described with reference to FIG. 1A through FIG.1J in the following.

Initially, as shown in FIG. 1A, the first seed film 2 is formed on a semiconductor substrate 1. After a photoresist of a predetermined height is spread on the first seed film 2, the first plating mold 3 having a plurality of grooves 3a is formed by exposing and developing processes as shown in FIG. 1B. After that, metal is filled up in the groove 3a of the first plating mold 3 through the process such as an electric plating so that a plurality of coil lines 4a, 4b,... may be formed as shown in FIG. 1 C. After that, the first plating mold 3 and the seed film under the plating mold 3 are removed so that the first coil 4 consisting of a plurality of coil lines 4a, 4b,...that are insulated each other may be formed as shown in FIG . 1D.

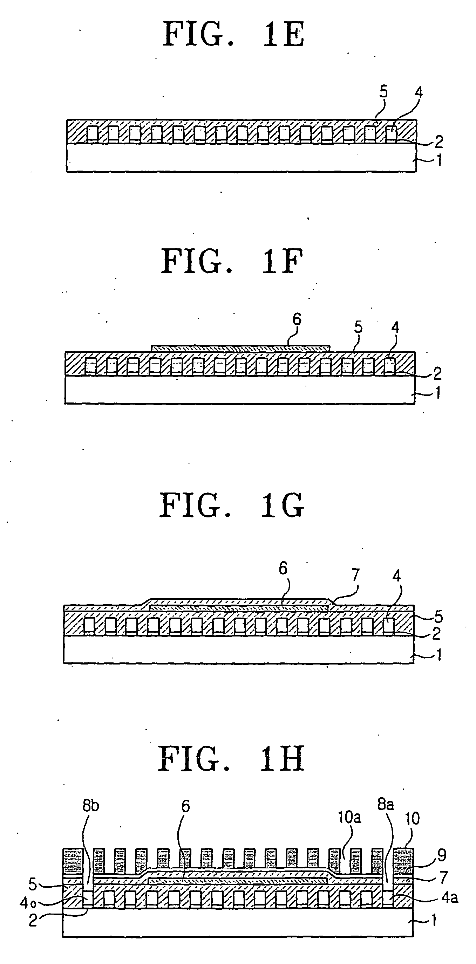

After the first coil 4 is formed, the first insulating film 5 is formed at the height higher than the height of the first coil 4 on the semiconductor substrate 1 as shown in FIG. 1E. After that, a soft magnetic material film is spread on the upper part of the first insulating film 5 and a soft magnetic core 6 is formed by a pattern formation and etching (refer to FIG 1F).

Subsequently, a second insulating film 7 of a predetermined thickness is formed on the soft magnetic core 6 of the semiconductor substrate 1 as shown in FIG. 1G, and as shown in FIG. 1H, via holes 8a, 8b for communicating with the coil lines 4a, 4o forming both ends of the first coil 4, are formed, and a second seed film 9 is formed in a predetermined thickness on the upper part of the second insulating film 7, then a photoresist is spread thick on the second seed film 9 and the second plating mold 10 having a plurality of grooves 10a is formed by exposing and developing processes.

After that, as shown in FIG. 1I, metal is filled up in the groove 10a of the second plating mold 10 so that a plurality of coil lines 11a, 11b,...may be formed. Then, the second plating mold 10 and the second seed film 9 under the second plating mold 10 are removed so that the second coil 11 consisting of a plurality of coil lines 11a, 11b,...that are insulated each other may be formed as shown in FIG. 1J.

Lastly, though not shown in the drawing, a protection film is spread on the upper part of the second coil 11, whereby manufacturing of the magnetic field detecting element is completed.

However, according to the foregoing general method for manufacturing the magnetic field detecting element, the seed film 2 between the coil lines 4a, 4b,...should be removed in order for each coil line 4a, 4b,...constituting the first coil 4 to be insulated from each other. For that purpose, after the first plating mold 3 is removed, the process of spreading the insulating film 5 again is added for the subsequent process, whereby the manufacturing process is complicated.

In the meantime, the performance of the soft magnetic core 6 in the foregoing magnetic field detecting element, is not very good in case that the semiconductor substrate 1 for supporting the core is not even. Since having a structure in which the first coil 4 projects from the semiconductor substrate 1, the general magnetic field detecting element has weak point that the thickness of the first and the second insulating films 5, 7 for insulation and planarization, becomes thick. If the thickness of the insulating films 5, 7 becomes thick, not only the whole thickness of the element becomes thick but also the process for forming the via holes 8a, 8b for connecting the first coil 4 with the second coil 11 becomes difficult. Also, a pitch between the coil lines that has an influence on the performance of the sensor gets large, which shows a negative effect.

EP 1 447 674 is prior art only for the purposes of Article 54(3) EPC and discloses a magnetic field sensing device and a fabrication method.

According to the invention, there is provided a method for manufacturing a magnetic field detecting element consisting of a soft magnetic core formed on a semiconductor substrate and first and second coils arranged on upper and lower parts of the soft magnetic core, and having a plurality of coil lines, respectively, the method comprising the steps of:
forming a seed film of a predetermined thickness on the semiconductor substrate;
removing the seed film using a predetermined pattern so that a plurality of coil lines constituting the first coil to be formed on the seed film are partitioned with respect to each other;
forming a first plating mold having a plurality of grooves that correspond to the predetermined pattern, on an upper part of the seed film;
forming a plurality of the coil lines constituting the first coil by filling up metal in the grooves of the first plating mold;
forming a soft magnetic core and the second coil on an upper part of the semiconductor substrate where the first coil is formed; and
cutting off four edges of the semiconductor substrate so that a plurality of the coil lines partitioned by the predetermined pattern are insulated from each other.

The step of removing the seed film further comprises the steps of: spreading a photoresist on an upper surface of the seed film; forming a predetermined pattern that would be removed, by exposing and developing the photoresist ; and etching the seed film according to the pattern.

Also, metal is filled up in the groove of the first plating mold with use of an electric plating.

Also, the step of forming a soft magnetic core further comprises the steps of: performing planarization of an upper surface of the semiconductor substrate on which the first coil is formed; spreading an insulating film on an upper surface of the semiconductor substrate for which planarization has been performed; spreading a soft magnetic material film on an upper part of the insulating film; forming a pattern of a soft magnetic core through exposing and developing processes after spreading a photoresist on the soft magnetic material film; and etching the soft magnetic material film according to the pattern.

Also, the step of forming a soft magnetic core could also be realized by another method comprising the steps of: removing the first plating mold; spreading an insulating film at a height higher than a height of the first coil, on an upper part of the semiconductor substrate from which the first plating mold has been removed; spreading a soft magnetic material film on an upper part of the insulating film; forming a pattern of a soft magnetic core through exposing and developing processes after spreading a photoresist on the soft magnetic material film; and etching the soft magnetic material film according to the pattern.

The may further comprise, before cutting off the edges:
forming a second insulating film on the semiconductor substrate where the soft magnetic core is formed;
forming a second seed film on an upper surface of the second insulating film;
forming a second plating mold having a plurality of grooves that corresponds to the second pattern, on an upper part of the second seed film;
forming a plurality of coil lines (136) constituting the second coil by filling up metal in the grooves of the second plating mold; and
removing the second seed film using a predetermined second pattern so that a plurality of coil lines constituting the second coil to be formed on the second seed film may be partitioned with respect to each other,
and wherein cutting off edges on four sides of the semiconductor substrate is such that a plurality of the coil lines constituting the first and the second coils partitioned by the first and the second patterns are insulated from each other.

The invention thus provides a method for manufacturing a magnetic field detecting element, wherein manufacturing process is simple and there are small restrictions in materials usable for an insulating film, since a plating mold does not need to be removed for removal of the seed film for insulation between coil lines.

The method is capable of easily performing planarization of the semiconductor substrate on which a coil is formed, and simplifies the process since the thickness of the planarization material is thin.

Examples of the invention will now be described in detail with reference to the accompanying drawings, in which:
FIG 1A through FIG. 1J are cross-sectional views for explaining the general method for manufacturing a magnetic field detecting element;
FIG 2A through FIG 2K are cross-sectional views for explaining a method for manufacturing a magnetic field detecting element according to an embodiment of the present invention;
FIG 3A is a plan view showing a status that a seed film formed on the semiconductor substrate is removed by a predetermined pattern;
FIG. 3B is a plan view showing a cut-off line for cutting off the semiconductor substrate in order to insulate coil lines after forming a plurality of coil lines on the seed film shown in FIG 3A;
FIG. 4 is a cross-sectional view for explaining a modified example of a method for manufacturing a magnetic field detecting element according to the present invention;
FIG 5A through FIG 5I are cross-sectional views for explaining a method for manufacturing a magnetic field detecting element according to another embodiment of the present invention;
FIG. 6A through FIG 6H are cross-sectional views for explaining another method for manufacturing a magnetic field detecting element; and
FIG. 7A through FIG 7H are cross-sectional views taken along line III-III of FIG 6A through FIG 6H, respectively.

A preferred embodiment of the present invention will now be described with reference to the accompanying drawings.

The detailed examples given are chosen to assist in a comprehensive understanding of the invention. Thus, it is apparent that the present invention can be carried out in other different ways. Also, well-known functions or constructions are not described in detail since they would obscure the invention in unnecessary detail.

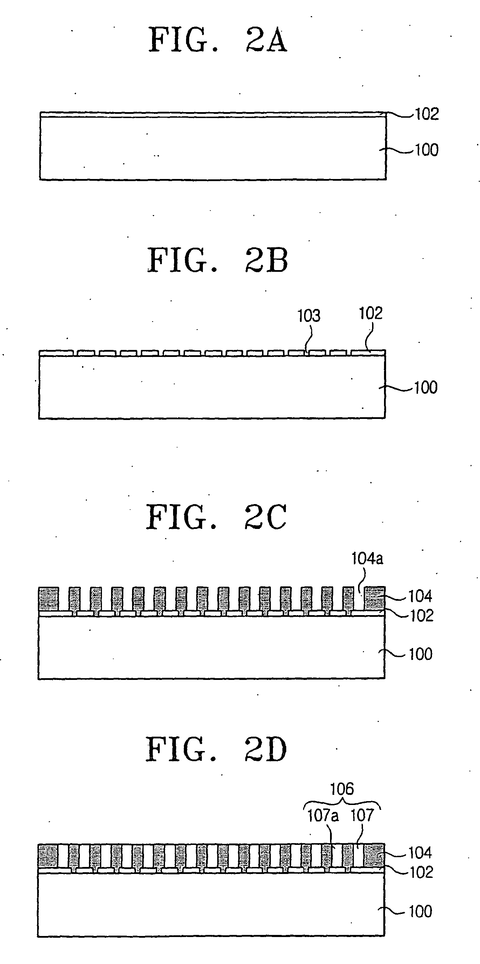

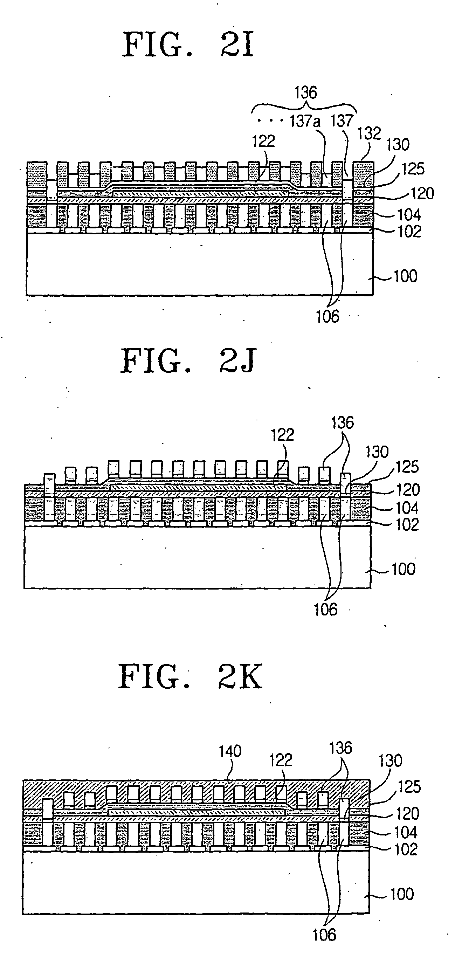

FIG 2A through FIG 2K are views showing process of a method for manufacturing a magnetic field detecting element according to an embodiment of the present invention. Referring to these drawings, the first step in the method for manufacturing a magnetic field detecting element according to an embodiment of the present invention is to form an oxidation film (not shown) for electric insulation, on a semiconductor substrate 100, and to form the first seed layer 102 for plating, on that oxidation film as shown in FIG. 2A.

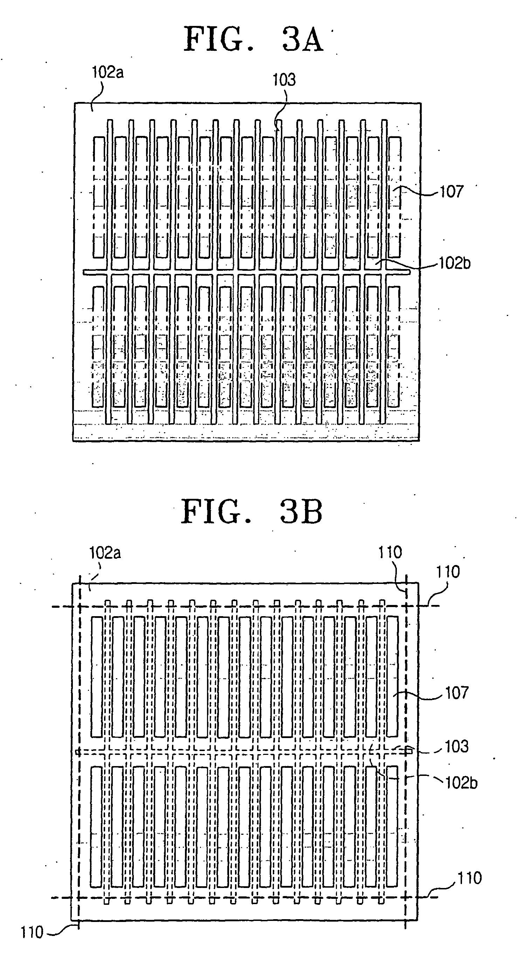

After that, as shown in FIG. 2B, the first seed film 102 spread on the semiconductor substrate 100 is partially removed with use of a predetermined pattern, i.e., the pattern as shown in FIG. 3A. The removal of the first seed film 102 is for insulating, in a simple manner, a plurality of coil lines constituting the first coil that would be formed on the first seed film 102 as will be described below. Here, the reference numerals 103 and 107 in FIG. 3A are a seed film pattern to be removed and a position of a plurality of the coil lines. As shown in the drawing, the pattern 103 is positioned between a plurality of the coil lines, whereby a plurality of the coil lines is partitioned from the neighboring coil lines and connected through the seed film at the edges. As a result, as shown in FIG. 3B, if four lines 110 connecting the edges of the pattern 103 are cut, the positions of the coil lines are insulated each other.

The removal of such first seed film 102 is performed in the following way, in which the seed film pattern 103 that would be removed by exposing and developing processes is formed after the photoresist is spread on the first seed film 102. At this time, the seed film pattern 103 that would be removed is formed in such a way that parts 102b where a plurality of coil lines 107 constituting the first coil 106 are to be formed, are insulated from each other and edges 102a are connected each other as shown in FIG. 3A.

The seed film 102 is electrically connected from the viewpoint of the whole semiconductor substrate 100, but the parts 102b where a plurality of the coil lines 107 constituting the first coil 106 would be formed, is formed in such a way that the parts 102b could be electrically insulated each other if the connection parts, i.e., the edges 102a are cut. Here, generally, the first coil is formed in such a way that an exciting coil and an magnetic field detecting coil are wired one time by turns. Also, only one of either the exciting coil or the magnetic field detecting coil may be wired in form of a solenoid. After that, the pattern 103 of the seed film 102 is removed through etching, then the photoresist is removed, whereby partial removal of the seed film is completed.

Then, after the photoresist is spread thick on the upper surface of the first seed film 102 that has been partially removed with use of a predetermined pattern 103, the first plating mold 104 having a plurality of grooves 104a is formed by exposing and developing processes (refer to FIG. 2C), and metal is filled in the groove 104a of the first mold 104, so that a plurality of coil lines 107, 107a constituting the first coil 106, is formed. At this time, by electric plating, metal sticks to and grows on the seed film in the lower part of the groove 104a of the first plating mold 104, whereby a plurality of coil lines 107, 107a is formed as shown in FIG. 2D.

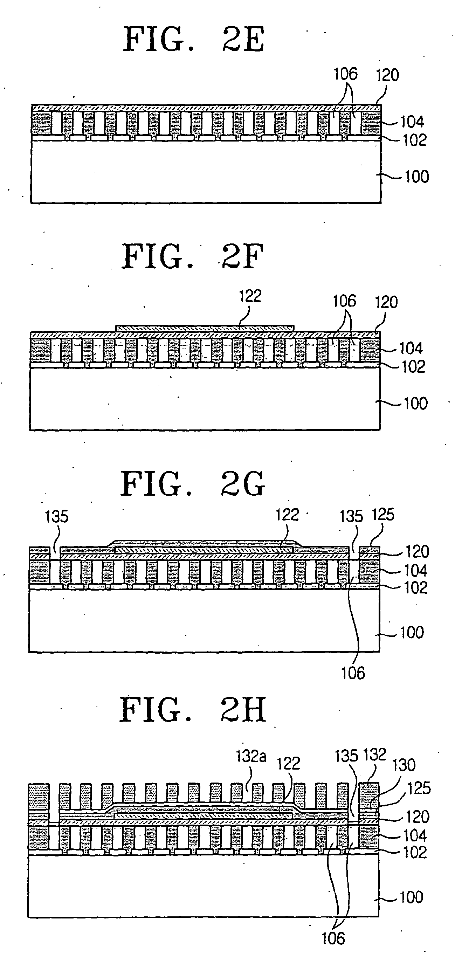

After that, with an upper surface of the first plating mold 104 processed evenly, a first insulating film 120 is formed in a predetermined thickness on that evenly processed upper surface as shown in FIG. 2E. Then, a soft magnetic material film is stacked on the upper part of the first insulating film 120 and a soft magnetic core 122 is formed by pattern formation and etching (refer to FIG 2F).

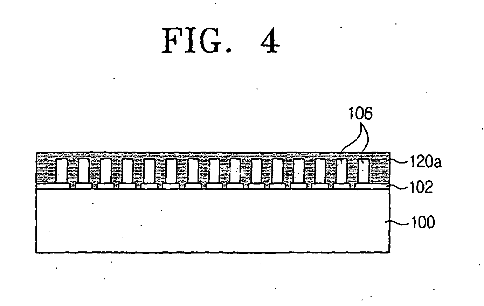

In the meantime, the insulating film for forming the soft magnetic core 122 may be formed in such a way that the first plating mold 104 is removed and the insulating material is spread in a height higher than a height of the first coil 106, on the semiconductor substrate 100 so that a first insulating film 120A is formed as shown in FIG. 4. According to such method, there is a strong point that planarization process needs not to be performed.

After the soft magnetic core 122 is formed in a foregoing manner, a second insulating film 125 is formed in a predetermined thickness, on the first insulating film 120 of the semiconductor substrate 100 as shown in FIG. 2G. Then, a via hole 135 for communicating with the coil lines that form both ends of the first coil 106, is formed at the second insulating film 125.

After that, as shown in FIG 2H, a second seed film 130 is formed on the upper surface of the second insulating film 125 and a photoresist is spread thick on the second seed film 130, then a second plating mold 132 having a pattern that corresponds to a shape of a second coil 136, i.e., a plurality of grooves 132a, is formed by exposing and developing processes. At this time, the second coil 136 which corresponds to the first coil 106, may be formed in such a way that an exciting coil and an magnetic field detecting coil are wired one time by turns, or only one of either the exciting coil or the magnetic field detecting coil may be wired in form of a solenoid.

After that, metal is filled in the groove 132a of the second plating mold 132 by electric plating so that a plurality of coil lines 137, 137a constituting the second coil 136 is formed (refer to FIG. 2I). Then, if the second plating mold 132 and the seed film under that second plating mold 132 are removed, a magnetic field detecting element having the second coil 136 is obtained as shown in FIG. 2J.

FIG. 2K shows that a protection film 140 for protecting structures including the second coil 136 is formed on the upper part of the second coil 136.

As described, after the first coil 106, the soft magnetic core 122, and the second coil 136 are formed on the semiconductor substrate 100, a portion 102a that corresponds to the edges of the first seed film 102 is cut off along a cut-off line 110 by dicing process as shown in FIG. 3B. Thus, as shown in the drawing, a plurality of the coil lines 107 constituting the first coil 106 is electrically separated and insulated each other.

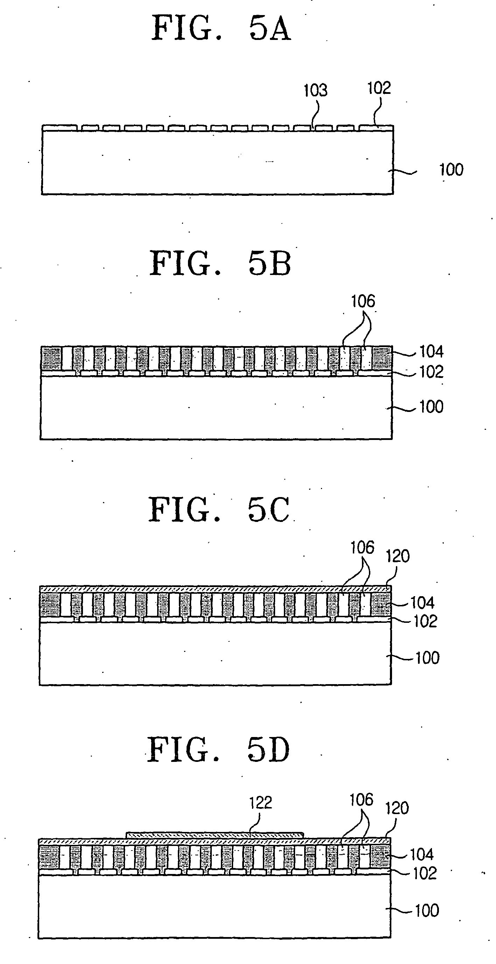

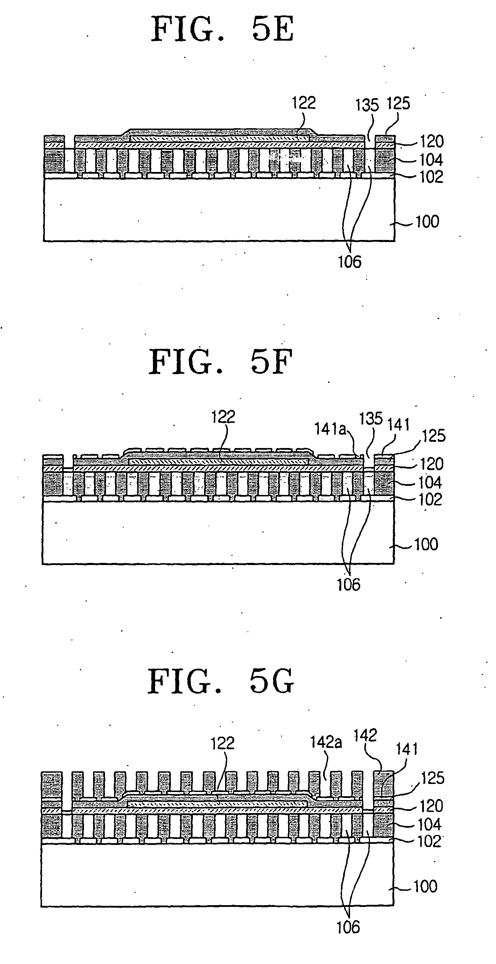

FIG. 5A through FIG. 51 are cross-sectional views showing another embodiment of the present invention. A method for manufacturing a magnetic field detecting element according to the embodiment of the present invention is characterized in applying the characteristic structure and process of the present invention in forming the second coil 136 as well as the above-described first coil 106, which will be described in the following.

Since the processes up to the process for forming the second insulating film 125 after forming the oxidation film on the semiconductor substrate 100, are the same as the process of the foregoing embodiment (refer to FIG. 5A through FIG. 5E), detailed description thereof will be omitted.

Next, as shown in FIG. 5F, a second seed film 141 is formed on the upper surface of the second insulating film 125, and that second seed film 141 is partially removed by the same method and pattern as those of the first seed film 102. Namely, after the photoresist is spread on the second seed film 141, a seed film pattern 141a to be removed is formed by exposing and developing processes. At this time, the seed film pattern 141 a to be removed, is formed in such a way that a plurality of the coil lines 137 constituting the second coil 136 are insulated from each other in their sides and a plurality of the coil lines 137 is connected by means of the edges of the seed film 141. Namely, the seed film pattern 141 a is formed in the same manner as the pattern 103 of the above-described first seed film 102.

Therefore, if the semiconductor substrate 100 is cut off along its edges, the coil lines 137 are electrically separated and insulated. At this time, it is preferable that the cut-off line (not shown) of the second coil 136 is overlapped on the cut-off line 110 of the first coil 106 so that a plurality of the coil lines 107, 137 constituting the first and the second coils 106, 136, respectively, is separated and insulated simultaneously by one time of dicing process.

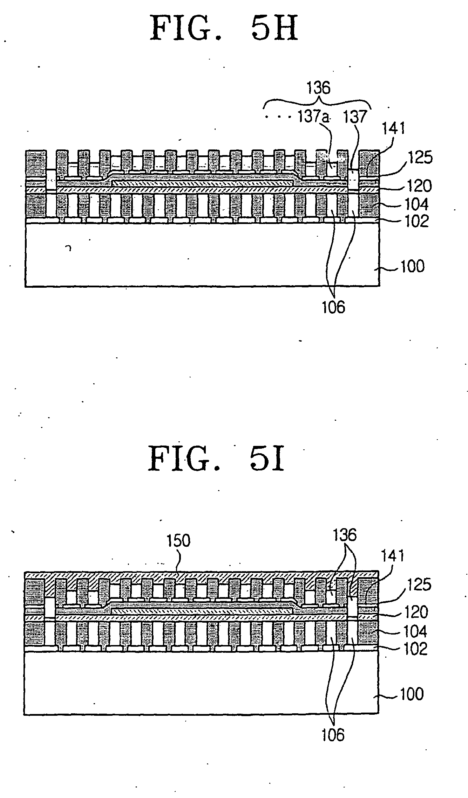

After that, the photoresist is spread thick on the upper surface of the second seed film 141 that has been partially removed by a predetermined pattern, then a second plating mold 142 having a pattern that corresponds to the second coil 136, i.e., a plurality of the grooves 142a, is formed by exposing and developing processes (refer to FIG.5G). After that, as shown in FIG. 5H, metal is filled in the groove 142a of the second plating mold 142 so that a plurality of the coil lines 137, 137a is formed.

Then, a protection film 150 is spread on the upper part of the structures including the second plating mold 142, and finally the semiconductor 100 is cut off according to a cut-off line 110 by the dicing process (refer to FIG. 3B).

Since the plating mold needs not to be removed for removal of the seed film as described above according to the method for manufacturing the magnetic field detecting element of the present invention, it is possible to provide the magnetic field detecting element such that the manufacturing process is simple and there are small restrictions in materials used for the insulating film.

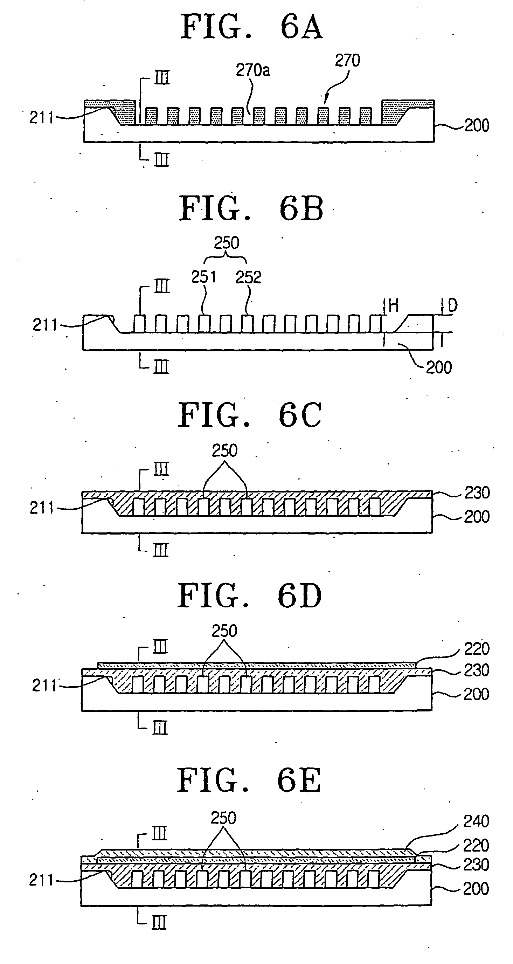

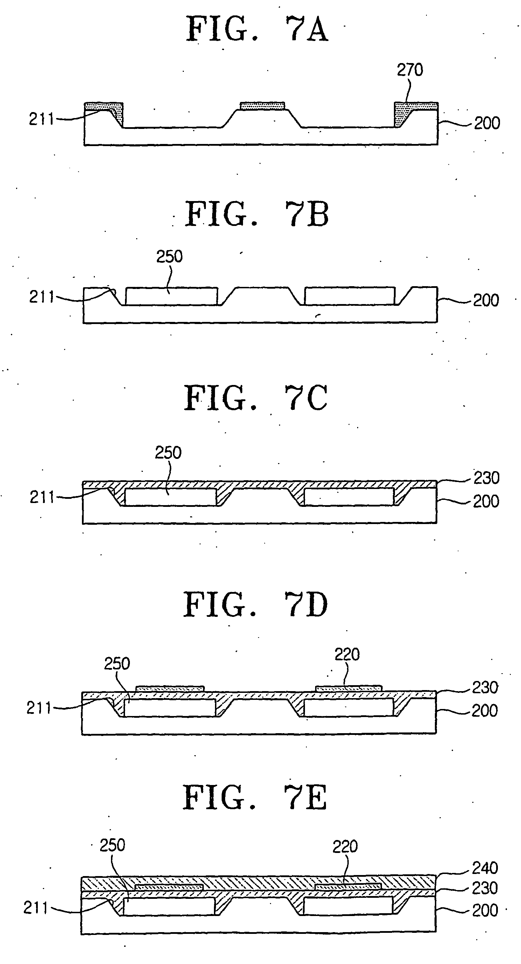

The accompanying FIG 6A through FIG 6H are drawings for explaining another method for manufacturing a magnetic field detecting element, and FIG. 7A through FIG. 7H are cross-sectional views taken along lines III-III of FIG. 6A through FIG. 6H, respectively.

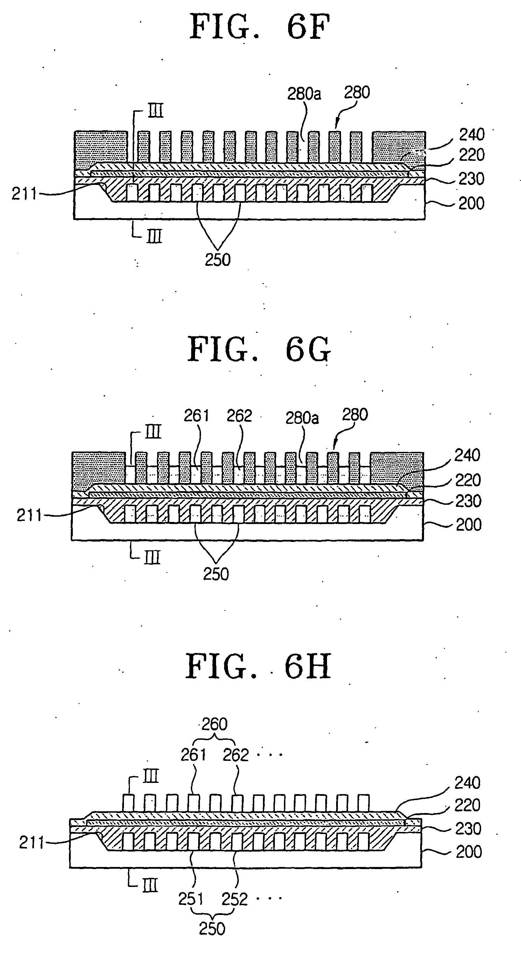

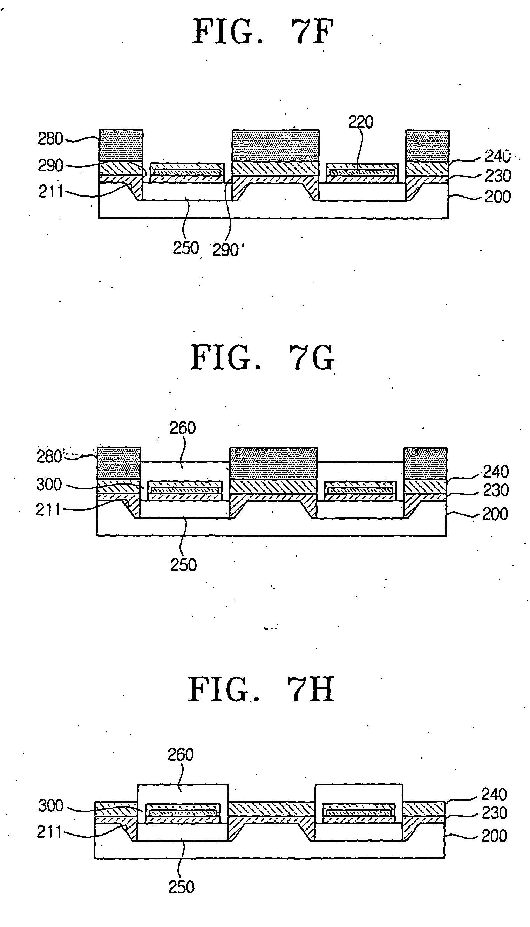

Referring to FIG. 6H and FIG. 7H, the magnetic field detecting element manufactured according to this method comprises: a semiconductor substrate 200; a soft magnetic core 220; the first and the second insulating films 230, 240 positioned at the upper and the lower parts of the soft magnetic core 220; and the first and the second coils 250, 260 formed in such a way that those coils enclose the soft magnetic core 220 with the soft magnetic core 220 and the insulating films 230, 240 intervened, and having a plurality of coil lines 251, 252,..., 261, 262,..., respectively.

The first coil 250 is positioned on the lower side of the soft magnetic core 220, and the second coil 260 is positioned on the upper side of the soft magnetic core 220. Particularly, the semiconductor substrate 200 has an approximately rectangular well 211 that collapses in a predetermined depth D from its surface and the first coil 250 is arranged in the inside of that well 211 so that the first coil 250 may not be exposed to the surface of the semiconductor substrate 200 according to the characteristics of the present invention.

The height H of a plurality of the coil lines 51 constituting the first coil 250 formed in the inside of the well 211 is the same as the depth of the well 211. Therefore, the upper surface of the coil lines 251 maintains the same plane as the upper surface of the semiconductor substrate 200.

As described above, unlike the conventional art, since the first coil 250 is not projected to the surface of the semiconductor substrate 200 but is formed in the same plane as the upper surface of the semiconductor substrate 200 in the inside of the well 211 of the semiconductor substrate 200, it is easy to perform planarization of the semiconductor substrate 200 in which the first coil 250 is formed and it is possible to make very thin the thickness of a planarization material, for example, the insulating films 230, 240.

Therefore, performance deterioration of the soft magnetic core 220 generated due to unevenness of the conventional semiconductor substrate and difficulty in etching process generated due to the characteristics that the thickness of the insulating film is thick, are resolved and the magnetic field detecting element of high sensitivity, wherein the pitch between the coils is fine, is possibly manufactured.

In the meantime, the approximately rectangular well 211 is formed in such a way that the well has an inclined sidewall that is gradually inclined in its inside from its upper part to its bottom and may be formed by a variety of the etching technologies generally well known.

Also, as shown in FIG 7F and FIG 7G the first and the second coils 250, 260 are connected, by means of a third coil 300 filled upon formation of the second coil 260, to through holes 290, 290' formed on both ends of the soft magnetic core 220 by passing through the first and the second insulating films 230, 240.

The method for manufacturing the magnetic field detecting element will be described in the following.

FIG. 6A and FIG. 7A are cross-sectional views showing that a first plating mold 270 for forming the first coil 250 is formed on the upper surface of the semiconductor substrate 200 in which the well 211 is formed. Although specifically not shown in the drawing, a seed film for plating is formed on the surface of the well 211, and the first plating mold 270 is formed by exposing and developing processes after the photoresist is spread thick on the seed film. In the drawing, the reference numeral 270a is a groove of the first plating mold 270.

If the seed film and the first plating mold are removed after metal is filled in such groove 270a of the first plating mold 270 by means of the electric plating method so that the coil line 251 is formed, the first coil 250 as shown in FIG. 6B and FIG. 7B is formed on the well 211 of the semiconductor substrate 200. The first coil 250 does not project beyond the surface of the semiconductor substrate 200 but formed in the same plane as the semiconductor substrate 200.

After that, as shown in FIG 6C and FIG. 7C, an insulating material is spread on the upper surface of the semiconductor substrate 200 in which the first coil 250 is formed, so that a first insulating film 230 for planarization and insulation, is formed. Since the first coil 250 does not project beyond the surface of the semiconductor substrate 200 but maintains the same plane as the semiconductor substrate, it is easy to perform planarization and it is possible to make the insulating film 230 very thin as well.

After the first insulating film 230 is formed, a soft magnetic material film is stacked on the first insulating film 230 and a soft magnetic core 220 is formed by pattern formation and etching as shown in FIG. 6D and FIG. 7D.

After that, an insulating material is spread in a predetermined thickness, on the upper part of the first insulating film 230 including the soft magnetic core 220 so that a second insulating film 240 as shown in FIG. 6E and FIG. 7E is formed.

After that, the portions that correspond to the both ends of the soft magnetic core 220 of the second insulating film 240, are etched so that the through holes 290, 290' as shown in FIG 7F are formed, and the process for forming the second coil 260 is proceeded. Since the thickness of the first and the second insulating films 230, 240 is formed very thin according to the characteristics of the present invention upon etching for formation of the through holes 290, 290', the etching process could be performed in a simple manner. Also, since it is possible to realize the fine-pitched coils due to such simplification of the process, the sensor of high sensitivity is possibly manufactured.

The formation of the second coil 260 is performed in such a way that firstly the seed film (not shown) is formed on the upper surface of the second insulating film 240 in which the through holes 290, 290' are formed, and the photoresist is spread on that seed film, then the second plating mold 280 having a plurality of grooves 280a is formed by exposing and developing processes as shown in FIG. 6F and FIG 7F.

After the foregoing second plating mold 280 is formed, metal is filled in the groove 280a of the plating mold 280 by means of the electric plating method so that a coil line 261 is formed as shown in FIG. 6G and FIG. 7G At this time, metal is filled in the through holes 290, 290', whereby the first coil 250 at the lower side is connected to the second coil 260 at the upper side by means of a third coil 300 that is filled in the through holes 290, 290'. Therefore, the coils 250, 260 are realized in such a way that these coils enclose the soft magnetic core 220.

If the seed film and the second plating mold 280 is removed after the coil line 261 is formed, the second coil 260 is exposed, whereby a thin type magnetic field detecting element as shown in FIG. 6H and FIG. 7H is manufactured. Here, the magnetic field detecting element manufactured by the present invention could reduce the whole height of the element as much as the depth of the well 211 formed on the semiconductor substrate 200, thus a thin structure is possibly realized.

In the meantime, on the upper part of the semiconductor substrate 200, a protection film for protecting the structures formed thereon could be formed.

As is apparent from the foregoing, according to the present invention, since the first coil is not projected to the upper part of the semiconductor substrate but positioned in the inside of the well, it is easy to perform planarization of the semiconductor substrate and it is possible to make thin the thickness of the planarization material as well. Therefore, performance improvement of the soft magnetic core is expected thanks to improvement in planarization degree, and simplification of the etching process for forming the through hole is expected thanks to realization of the thin insulating film. Also, the pitch between the coils could be reduced thanks to simplification of the etching process, thus the sensitivity of the sensor could be improved.

Namely, according to the present invention, manufacturing of the magnetic field detecting element is simplified, whereby productivity improvement is expected and the thin-type element of good sensitivity is possibly manufactured as well.

## Claims

1. A method for manufacturing a magnetic field detecting element consisting of a soft magnetic core formed on a semiconductor substrate (100) and first (106) and second (136) coils arranged on upper and lower parts of the soft magnetic core, and having a plurality of coil lines, respectively, the method comprising the steps of:
forming a seed film (102) of a predetermined thickness on the semiconductor substrate (100);
removing the seed film using a predetermined pattern so that a plurality of coil lines (106) constituting the first coil to be formed on the seed film are partitioned with respect to each other;
forming a first plating mold (104) having a plurality of grooves (107) that correspond to the predetermined pattern, on an upper part of the seed film (102);
forming a plurality of the coil lines (106) constituting the first coil by filling up metal in the grooves (107) of the first plating mold;
forming a soft magnetic core (122) and the second coil on an upper part of the semiconductor substrate where the first coil is formed; and
cutting off (110) four edges of the semiconductor substrate so that a plurality of the coil lines partitioned by the predetermined pattern are insulated from each other.

2. The method according to claim 1, wherein the step of removing the seed film further comprises the steps of: spreading a photoresist on an upper surface of the seed film (102); forming a predetermined pattern (103) to be removed, by exposing and developing the photoresist; and etching the seed film according to the pattern.

3. The method according to claim 1 or 2, wherein metal is filled up in the grooves (107) of the first plating mold by means of electric plating.

4. The method according to any preceding claim, wherein the step of forming the soft magnetic core further comprises the steps of:
performing planarization of an upper surface of the semiconductor substrate on which the first coil is formed;
spreading an insulating film (120) on an upper surface of the semiconductor substrate for which planarization has been performed;
spreading a soft magnetic material film (122) on an upper part of the insulating film;
forming a pattern of the soft magnetic core through exposing and developing processes after spreading a photoresist on the soft magnetic material film; and
etching the soft magnetic material film according to the pattern.

5. The method according to any one of claims 1 to 3, wherein the step of forming the soft magnetic core further comprises the steps of:
removing the first plating mold;
spreading an insulating film at a height higher than a height of the first coil, on an upper part of the semiconductor substrate from which the first plating mold has been removed;
spreading a soft magnetic material film on an upper part of the insulating film;
forming a soft magnetic core pattern through exposing and developing processes after spreading a photoresist on the soft magnetic material film; and
etching the soft magnetic material film according to the pattern.

6. The method according to any preceding claim, wherein the method further comprises, before cutting off the edges:
forming a second insulating film (125) on the semiconductor substrate where the soft magnetic core is formed;
forming a second seed film (130) on an upper surface of the second insulating film (125);
removing the second seed film (130) using a predetermined second pattern so that a plurality of coil lines constituting the second coil to be formed on the second seed film may be partitioned with respect to each other;
forming a second plating mold (132) having a plurality of grooves that corresponds to the second pattern, on an upper part of the second seed film (130); and
forming a plurality of coil lines (136) constituting the second coil by filling up metal in the grooves of the second plating mold (132);
and wherein cutting off (110) edges on four sides of the semiconductor substrate is such that a plurality of the coil lines constituting the first and the second coils partitioned by the first and the second patterns are insulated from each other.

## Patentansprüche

1. Verfahren zur Herstellung eines Magnetfelddetektors, bestehend aus einem weichen Magnetkern, der auf einem Halbleitersubstrat (100) gebildet ist, und ersten (106) und zweiten (136) Wicklungen, die an oberen und unteren Teilen des weichen Magnetkern angeordnet sind und die mehrere entsprechende Wicklungsreihen aufweisen, wobei das Verfahren die Schritte umfasst:
Bilden einer Keimschicht (102) von vorbestimmter Dicke auf dem Halbleitersubstrat (100);
Entfernen der Keimschicht, indem eine vorbestimmte Struktur benutzt wird, derart, dass mehrere Wicklungsreihen (106), die die erste Wicklung erzeugen, die auf der Keimschicht gebildet wird, voneinander getrennt sind;
Bilden einer ersten Beschichtungsform (104), die mehrere Nuten (107) aufweist, die einer vorbestimmten Struktur entsprechen, auf einem oberen Teil der Keimschicht (102);
Bilden mehrerer Wicklungsreihen (106), die die erste Wicklung erzeugen, indem Metall in die Nuten (107) der ersten Beschichtungsform aufgefüllt wird;
Bilden des weichen Magnetkerns (122) und der zweiten Wicklung auf einem oberen Teil des Halbleitersubstrats, wo die erste Wicklung gebildet ist; und
Abschneiden (110) von vier Rändern des Halbleitersubstrats, derart, dass mehrere der Wicklungsreihen, die durch die vorbestimmte Struktur getrennt sind, voneinander isoliert sind.

2. Verfahren nach Anspruch 1, wobei der Schritt des Entfernens der Keimschicht ferner die Schritte umfasst: Verteilen eines Photolacks auf eine obere Fläche der Keimschicht (102); Bilden einer vorbestimmten Struktur (103), die entfernt wird durch Belichten und Entwickeln des Photolacks; und Ätzen der Keimschicht entsprechend der Struktur.

3. Verfahren nach Anspruch 1 oder 2, wobei Metall in die Nuten (107) der ersten Beschichtungsform mittels elektrischer Beschichtung aufgefüllt wird.

4. Verfahren nach einem der vorhergehenden Ansprüche, wobei der Schritt des Bildens des weichen Magnetkerns ferner die Schritte umfasst:
Ausführen einer Planarisierung einer oberen Fläche des Halbleitersubstrats, auf welchem die erste Wicklung gebildet ist;
Verteilen einer Isolierschicht (120) auf eine obere Fläche des Halbleitersubstrats, für welches die Planarisierung ausgeführt wurde;
Verteilen einer weichen magnetischen Materialschicht (122) auf einen oberen Teil der Isolierschicht;
Bilden einer Struktur des weichen Magnetkerns durch Belichtungs- und Entwicklungsprozesse, nach dem Verteilen eines Photolacks auf der weichen magnetischen Materialschicht; und
Ätzen der weichen magnetischen Materialschicht entsprechend der Struktur.

5. Verfahren nach einem der Ansprüche 1 bis 3, wobei der Schritt des Bildens des weichen Magnetkerns ferner die Schritte umfasst:
Entfernen der ersten Beschichtungsform;
Verteilen einer Isolierschicht auf eine Höhe, die höher ist als die Höhe der ersten Wicklung, auf einen oberen Teil des Halbleitersubstrats, von dem die erste Beschichtungsform entfernt worden ist;
Verteilen einer weichen magnetischen Materialschicht auf einen oberen Teil der Isolierschicht;
Bilden einer Struktur eines weichen Magnetkerns durch Belichtungs- und Entwicklungsprozesse, nach dem Verteilen eines Photolacks auf der weichen magnetischen Materialschicht; und
Ätzen der weichen magnetischen Materialschicht entsprechend der Struktur.

6. Verfahren nach einem der vorhergehenden Ansprüche, wobei das Verfahren, bevor die Ränder abgeschnitten werden, ferner umfasst:
Bilden einer zweiten Isolierschicht (125) auf dem Halbleitersubstrat, wo der weiche Magnetkern gebildet ist;
Bilden einer zweiten Keimschicht (130) auf einer oberen Fläche der zweiten Isolierschicht (125);
Entfernen der zweiten Keimschicht (130), indem eine vorbestimmte zweite Struktur benutzt wird, derart, dass mehrere Wicklungsreihen, die die zweite Wicklung erzeugen, die auf der zweiten Keimschicht gebildet wird, mit Bezug zueinander segmentiert werden können;
Bilden einer zweiten Beschichtungsform (132), die mehrere Nuten aufweist, die der zweiten Struktur entsprechen, auf einem oberen Teil der zweiten Keimschicht (130); und
Bilden mehrerer Wicklungsreihen (136), die die zweite Wicklung erzeugen, indem Metall in die Nuten der zweiten Beschichtungsform (132) aufgefüllt wird;
und wobei das Abschneiden (110) der Ränder an vier Seiten des Halbleitersubstrats derart stattfindet, dass mehrere der Wicklungsreihen, die die ersten und zweiten Wicklungen erzeugen, die durch die ersten und zweiten Strukturen segmentiert sind, voneinander isoliert sind.

## Revendications

1. Procédé pour fabriquer un élément de détection de champ magnétique constitué par un noyau magnétique doux formé sur un substrat semiconducteur (100) et par des premières (106) et secondes (136) bobines agencées sur les parties supérieure et inférieure du noyau magnétique doux, et comportant respectivement une pluralité de lignes de bobines, le procédé comprenant les étapes de :
formation d'un film de germe (102) d'une épaisseur prédéterminée sur le substrat semiconducteur (100) ;
enlèvement du film de germe en utilisant un motif prédéterminé de telle sorte qu'une pluralité de lignes de bobines (106) constituant la première bobine à former sur le film de germe soient partitionnées les unes par rapport aux autres ;
formation d'un premier moule de placage (104) comportant une pluralité de gorges (107) qui correspondent au motif prédéterminé, sur une partie supérieure du film de germe (102) ;
formation d'une pluralité des lignes de bobines (106) constituant la première bobine en remplissant un métal dans les gorges (107) du premier moule de placage ;
formation d'un noyau magnétique doux (122) et de la seconde bobine sur une partie supérieure du substrat semiconducteur où la première bobine est formée ; et
découpe (110) de quatre bords du substrat semiconducteur de telle sorte qu'une pluralité des lignes de bobines partitionnées au moyen du motif prédéterminé soient isolées les unes des autres.

2. Procédé selon la revendication 1, dans lequel l'étape d'enlèvement du film de germe comprend en outre les étapes de : étalement d'une photoréserve sur une surface supérieure du film de germe (102) ; formation d'un motif prédéterminé (103) destiné à être enlevé en exposant et en développant la photoréserve ; et gravure du film de germe conformément au motif.

3. Procédé selon la revendication 1 ou 2, dans lequel un métal est rempli dans les gorges (107) du premier moule de placage au moyen d'un placage électrique.

4. Procédé selon l'une quelconque des revendications précédentes, dans lequel l'étape de formation du noyau magnétique doux comprend en outre les étapes de :
réalisation d'une planarisation d'une surface supérieure du substrat semiconducteur sur laquelle la première bobine est formée ;
étalement d'un film isolant (120) sur une surface supérieure du substrat semiconducteur pour laquelle une planarisation a été réalisée ;
étalement d'un film en matériau magnétique doux (122) sur une partie supérieure du film isolant ;
formation d'un motif du noyau magnétique doux par l'intermédiaire de processus d'exposition et de développement après étalement d'une photoréserve sur le film en matériau magnétique doux ; et
gravure du film en matériau magnétique doux conformément au motif.

5. Procédé selon l'une quelconque des revendications 1 à 3, dans lequel l'étape de formation du noyau magnétique doux comprend en outre les étapes de :
enlèvement du premier moule de placage ;
étalement d'un film isolant à une hauteur plus haute qu'une hauteur de la première bobine, sur une partie supérieure du substrat semiconducteur de laquelle le premier moule de placage a été enlevé ;
étalement d'un film en matériau magnétique doux sur une partie supérieure du film isolant ;
formation d'un motif de noyau magnétique doux par l'intermédiaire de processus d'exposition et de développement après étalement d'une photoréserve sur le film en matériau magnétique doux ; et
gravure du film en matériau magnétique doux conformément au motif.

6. Procédé selon l'une quelconque des revendications précédentes, dans lequel le procédé comprend en outre, avant la découpe des bords :
la formation d'un second film isolant (125) sur le substrat semiconducteur où le noyau magnétique doux est formé ;
la formation d'un second film de germe (130) sur une surface supérieure du second film isolant (125) ;
l'enlèvement du second film de germe (130) en utilisant un second motif prédéterminé de telle sorte qu'une pluralité de lignes de bobines constituant la seconde bobine à former sur le second film de germe puissent être partitionnées les unes par rapport aux autres ;
la formation d'un second moule de placage (132) comportant une pluralité de gorges qui correspondent au second motif, sur une partie supérieure du second film de germe (130) ; et
la formation d'une pluralité de lignes de bobine (136) constituant la seconde bobine en remplissant un métal dans les gorges du second moule de placage (132), et dans lequel :
une découpe (110) de bords sur les quatre côtés du substrat semiconducteur est telle qu'une pluralité des lignes de bobines constituant les premières et secondes bobines partitionnées par les premier et second motifs soient isolées les unes des autres.
